# EUROPÄISCHE PATENTANMELDUNG

(11) **EP 2 259 335 A1**
(43) Veröffentlichungstag der Anmeldung: **08.12.2010**
(21) Anmeldenummer: 10162909.5
(22) Anmeldetag: 17.05.2010
(51) Int. Cl.: H01L 31/048, B32B 17/10, C03C 27/12, C08K 5/103, C08L 29/14

(54) **Photovoltaikmodule enthaltend plastifizierte Zwischenschicht-Folien mit reduzierter Eigenklebrigkeit**

(30) Priorität: 15.05.2009 EP 09160334
(71) Anmelder: Kuraray Europe GmbH, 65926 Frankfurt am Main (DE)
(72) Erfinder: Beekhuizen, Jan, Dr., 53844, Troisdorf (DE)
(74) Vertreter: Kisters, Michael Marcus

(57) **Zusammenfassung**

Die Erfindung betrifft die Verwendung von weichmacherhaltigen, auf Polyvinylacetal basierenden Folien, welche eine niedrige Eigenklebrigkeit aufweisen, zur Herstellung von Photovoltaikmodulen.

Die niedrige Eigenklebrigkeit kann durch den Zusatz von Mono-, Di-, Tri oder Tetra-Pentaerythritestern eingestellt werden.

## Beschreibung

### Technisches Gebiet

Die Erfindung betrifft die Verwendung von weichmacherhaltigen Folien auf Basis von Polyvinylacetal mit reduzierter Eigenklebrigkeit zur Herstellung von Photovoltaikmodulen.

### Stand der Technik

Photovoltaikmodule bestehen aus einer photosensitiven Halbleiterschicht, die zum Schutz gegen äußere Einflüsse mit einer transparenten Abdeckung versehen wird. Als photosensitive Halbleiterschicht können monokristalline Solarzellen oder polykristalline, dünne Halbleiterschichten auf einem Träger eingesetzt werden. Dünnschicht-Solarmodule bestehen aus einer photosensitiven Halbleiterschicht, die auf ein Substrat wie z.B. eine transparente Platte oder eine flexible Trägerfolie z.B. durch Aufdampfen, Gasphasenabscheidung, Sputtern oder Nassabscheidung aufgebracht ist.

Beide Systeme werden häufig zwischen eine Glasscheibe und eine rigide, hintere Abdeckplatte z.B. aus Glas oder Kunststoffen mit Hilfe eines transparenten Klebers laminiert.

Der transparente Kleber muss die photosensitive Halbleiterschicht und deren elektrische Verbindungsleitungen vollständig umschließen, U V-stabil und Feuchtigkeitsunempfindlich sein und nach dem Laminierprozess vollständig blasenfrei sein.

Als Klebesysteme werden häufig weichmacherhaltige Folien auf Basis von Polyvinylacetalen wie das aus der Verbundglasherstellung bekannte Polyvinylbutyral (PVB) verwendet. Verfahren zur Herstellung von Solarmodulen mit Hilfe von PVB-Folien sind z. B. durch DE 40 26 165 C2, DE 42 278 60 A1, DE 29 237 70 C2, DE 35 38 986 C2 oder US 4,321,418 bekannt. Die Verwendung von PVB-Folien in Solarmodulen als Verbundsicherheitsverglasungen ist z.B. in DE 20 302 045 U1, EP 1617487 A1 und DE 35 389 86 C2 offenbart.

Nachteilig an derartigen Systemen ist die hohe Eigenklebrigkeit von weichmacherhaltigen PVB-Folien.

Weichmacherhaltige Folien auf Basis von Polyvinylbutyral werden in der Regel extrudiert und nach der Formgebung in Breitschlitzwerkzeugen zu großen Rollen aufgewickelt. PVB-Folien weisen jedoch nicht nur eine gute Haftung gegenüber Glas, sondern auch gegenüber der benachbarten Wickellage der Rollen auf. Diese auch Blocking-Neigung genannte Eigenschaft erschwert die Handhabung der Folien insbesondere beim Auf- bzw. Abwickeln.

Es sind in einem anderen technischen Gebiet, der Verbundglasherstellung, viele Versuche unternommen worden, die Blocking-Neigung von PVB-Folien zu unterdrücken. Die Blocking-Neigung von PVB-Folien kann z.B. durch Modifikation des PVB-Harzes oder der Weichmacher verringert werden (US 4,999,078 A1, EP 0 067 022 B2). Nachteil dieser Verfahren ist, dass modifizierte PVB-Harze oder Weichmacher kommerziell nur sehr eingeschränkt verfügbar sind. Diese Alternativen konnten sich daher auf dem Markt bislang nicht durchsetzen.

Weiterhin ist auf dem Gebiet der Verbundglasherstellung die Verwendung von so genannten Antiblockmitteln, d.h. von speziellen Additiven, die in der Regel einen wachsartigen Charakter haben, bekannt. So beschreiben WO 03/051974, WO 2005/005525 A2, EP 2067813 und DE 100 64 373 Fettsäurediamide, insbesondere Stearinsäurediamid, EP 1 430 094 B1 Pentaerythritester, WO 2004111116 A1 ionische Tenside, WO 2004111115 A1 amphiphile Polyethylen-Polyethylenglykolen und US 20040219365 mono-Amide von Fettsäurerestern zur Verwendung als Antiblockmittel in PVB-Folien zur Reduzierung deren Eigenklebrigkeit. Der Einsatz dieser Folien in Photovoltaik-Modulen ist hier nicht beschrieben.

Zudem resultieren alle diese Verfahren in einer mehr oder weniger starken Trübung der PVB-Folie, da die eingesetzten Antiblocking-Mittel auskristallisieren oder mit dem Weichmacher oder der Polymermatrix unverträglich sind. Die Trübungen, sog. Haze, können auch nach der Verarbeitung bzw. nach einigen Monaten Lagerzeit auftreten. Für Verbundverglasungen, wo es auf eine hohe optische Transparenz ankommt, sind diese Systeme ungeeignet und haben sich nicht durchgesetzt.

PVB-Folien werden daher nahezu ausschließlich entweder mit PE-Zwischenläuferfolien oder als sogenannte Kühlfolie ausgeliefert. Die Verwendung von Zwischenläuferfolien aus Polyethylen hat zwar den Vorteil das PVB-Folie nicht an Polyethylen klebt, allerdings muss diese nach dem Abwickeln der PVB-Folie entsorgt werden. Bei der Lieferung als Kühlfolie wird die PVB-Folie noch vor dem Aufwickeln auf eine Temperatur von 4 - 10 °C gekühlt, wodurch die Blockingneigung unterdrückt wird. Die fertigen Folienwickel müssen ohne Unterbrechung der Kühlkette bis zur Weiterverarbeitung bei einer Temperatur von unter 10° C transportiert werden. Dadurch entstehen sowohl dem Hersteller als auch dem Verarbeiter neben einem aufwändigeren Handling auch höhere Kosten.

Der kommerzielle Einsatz von Folien mit einem reduzierten Blockingverhalten für Photovoltaik-Module ist nicht bekannt. Die aus der Verbundglasherstellung bekannten Probleme solcher Folien scheinen einen Einsatz als Verkapselungsmaterial in Photovoltaik-Modulen verhindert zu haben. Lediglich EP 2067813 offenbart die Verwendung von Glycol- und Glycarinestern in Photovoltaikmodulen ohne jedoch die erforderliche Blockingkraft oder die Lichtdurchlässigkeit der Folie anzugeben.

### Aufgabe

Es besteht daher gerade für die Photovoltaik-Industrie ("green energy") im Hinblick auf die Umweltbilanz (Energiekosten, CO₂-Emission) Bedarf an einer PVB-Folie ohne PE-Zwischenläufer und ohne notwendige Kühlung.

Aufgabe der vorliegenden Erfindung war es, eine weichmacherhaltige Folie auf der Basis von Polyvinylacetal zur Verfügung zu stellen, die eine verringerte Eigenklebrigkeit bzw. ein reduziertes Blockingverhalten, aber eine ausreichende Transparenz zur Verwendung in Photovoltaikmodulen aufweist.

Gegenstand der vorliegenden Erfindung ist daher die Verwendung von weichmacherhaltigen, auf Polyvinylacetal basierenden Folien, die eine im T-peel-strength-Test gemäß EP 0067022 B2 bestimmte Eigenhaftung von weniger als 25 N/30 mm und eine Lichtdurchlässigkeit TL nach DIN EN410 von mehr als 85 % aufweisen, zur Herstellung von Photovoltaikmodulen umfassend ein Laminat aus
a) einer transparenten Frontabdeckung
b) einer oder mehreren photosensitiven Halbleiterschichten
c) mindestens einer weichmacherhalteigen, auf Polyvinylacetal basierenden Folie und
d) einer rückwärtigen Abdeckung,
   wobei die Folie c) 0,001 bis 5 Gew.% mindestens eines der Antiblockmittel ausgewählt aus der Gruppe Ester von mehrwertigen Alkoholen mit mehr als drei Kohlenstoffatomen mit unverzweigten oder verzweigten (Guerbet-Ester), ungesättigten oder gesättigten aliphatischen Carbonsäuren mit 12-26 C-Atomen, Diester von bifunktionellen Alkoholen oder Säuren mit ungesättigten oder gesättigten, verzweigten oder unverzweigten aliphatischen Carbonsäuren bzw. Alkoholen mit 12-26 C-Atomen (Esterwachse), Ester von ungesättigten oder gesättigten, verzweigten oder unverzweigten aliphatischen Carbonsäuren mit 12-26 C-Atomen mit ungesättigten oder gesättigten, verzweigten oder unverzweigten aliphatischen Alkoholen mit 12-26 C-Atomen, Bisamide oligofunktioneller Alkylenamine von ungesättigten oder gesättigten aliphatischen Carbonsäuren mit 12-26 C-Atomen (Amidwachse) enthält.

Erfindungsgemäß eingesetzte Folien können ohne Kühlung geliefert und zu Photovoltaikmodulen verarbeitet werden. Hiermit wird der Aufwand des Herstellers von Photovoltaikmodulen deutlich reduziert, da auf gekühlte Lager- und Verarbeitungsräume verzichtet werden kann.

Bevorzugt weisen die erfindungsgemäß eingesetzten Folien eine im T-peel-strength-Test gemäß EP 0067022 B2 bestimmte Eigenhaftung von 0,1 bis 23 N/30 mm, besonders bevorzugt von 0,1 - 20 N/30 mm, oder 0,1 - 15 N/30 mm und insbesondere von 0,1 - 10 N/30 mm auf.

Der T-peel-strength-Test gemäß EP 0067022 B2 wird an glatten Folien d.h. Folien mit einer Rauhigkeit R_{z} von weniger als 10 µm und einer Dicke von 0,76 mm durchgeführt. Üblicherweise besitzen PVB-Folien eine höhere Rauhigkeit womit die Eigenhaftung bereits reduziert werden kann. Folien mit erhöhter Rauhigkeit müssen vor der Durchführung des T-peel-strength-Tests glatt abgepresst werden.

Bevorzugt enthalten die weichmacherhaltigen Folien c) als Antiblockmittel 0,01-2 Gew.%, besonders bevorzugt 0,03-1 Gew.% mindestens eines der Antiblockmittel ausgewählt aus der Gruppe Ester von Ethylenglykol, Propylenglykol, Glycerin, Neopentylglykol oder Pentaerythrit mit gesättigten aliphatischen Carbonsäuren mit 12-26 C-Atomen wie z.B. Pentaerythrittetrastearat, Diester von bifunktionellen Alkoholen oder Säuren wie Ethylenglykol oder Adipinsäure mit gesättigten aliphatischen Carbonsäuren bzw. Alkoholen mit 12-2 6 C-Atomen wie z.B. Ethylenglykoldistearat, Ester von gesättigten, aliphatischen Carbonsäuren mit 12-26 C-Atomen mit gesättigten, aliphatischen Alkoholen mit 12-26 C-Atomen wie z.b. Stearylstearat, Fettsäureamide gesättigter aliphatischer Carbonsäuren mit 12-26 C-Atomen wie z.B. Stearinsäureamid.

Besonders geeignet als Antiblockmittel für die vorliegende Erfindung sind Mono-, Di-, Tri oder Tetra-Pentaerythritester der allgemeinen Formel I 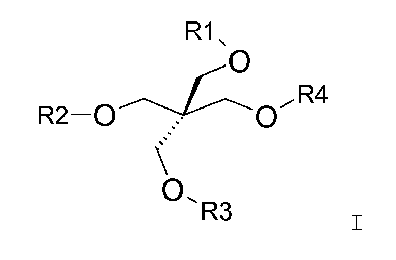 mit R1, R2, R3, R4 = -CO-Alkyl, mit Alkyl= 10-25 C-Atome, oder H; wobei R1, R2, R3, R4 jeweils gleich oder unterschiedlich sein können, aber nicht gleichzeitig H bedeuten. Verbindungen dieser Art sind z.B. unter den Handelsnamen "Glycolube" von der Fa. Lonza oder von der Fa. Undessa erhältlich.

Besonders bevorzugt wird gemäß Formel I das Pentaerythrittetrastearat mit R1, R2, R3, R4 = -C17H35 (Formel II) eingesetzt.

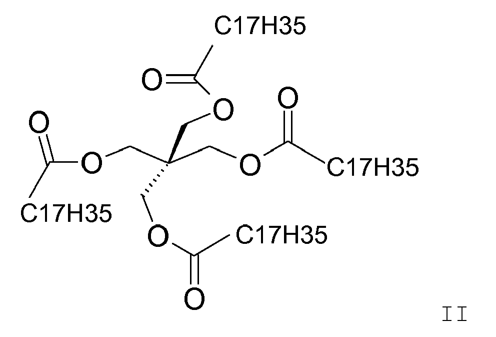

Bevorzugt weisen die erfindungsgemäß eingesetzten Folien bei einer Umgebungsfeuchte von 85% rF bei 23°C einen spezifischen Widerstand von mindestens 5E+12 ohm*cm, besonders bevorzugt von mindestens 1E+13 ohm*cm, insbesondere von mindestens 5E+13 auf.

Die erfindungsgemäß verwendeten Folien können eine gewisse Trübung aufweisen, ohne dass die Funktion der Photovoltaikmodule beeinträchtigt wird, sofern die geforderte Lichtdurchlässigkeit TL erreicht wird. So kann die als Haze bezeichnete Trübung einer glatt abgepressten Folie zwischen 0,1 und 20, bevorzugt zwischen 0,5 und 10 und insbesondere zwischen 1 und 5 liegen.

Das zur Herstellung der erfindungsgemäß eingesetzten Folie c) verwendete Polyvinylacetal wird durch Reaktion von Polyvinylalkohol in Wasser mit einem Aldehyd wie Butyraldehyd unter Zusatz eines Säurekatalysators hergestellt. Das ausgefallene Polyvinylacetal wird abgetrennt, neutral gewaschen, ggf. in einem alkalisch eingestellten wässrigen Medium suspendiert, danach erneut neutral gewaschen und getrocknet.

Die zur Acetalisierung eingesetzte Säure muss nach erfolgter Reaktion wieder neutralisiert werden. Wird hier ein Überschuss an Base (z.B. NaOH, KOH oder Mg(OH)₂) eingesetzt, so erhöht sich der Alkalititer und es kann ganz oder teilweise auf die Zugabe der basischen Substanz verzichtet werden.

Der Polyvinylalkoholgehalt des Polyvinylacetals kann durch die Menge des bei der Acetalisierung eingesetzten Aldehyds eingestellt werden. Es ist auch möglich, die Acetalisierung mit anderen oder mehreren Aldehyden mit 2-10 Kohlenstoffatomen (z.B. Valeraldehyd) durchzuführen.

Die auf weichmacherhaltigem Polyvinylacetal basierenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98 Mol% hydrolysiert und enthalten 1 bis 10 Gew. auf Ethylen basierende Einheiten (z.B. Typ " Exceval" der Kuraray Europe GmbH).

Als Polyvinylalkohol können im Rahmen der vorliegenden Erfindung weiterhin auch hydrolysierte Copolymere aus Vinylacetat und mindestens einem weiteren ethylenisch ungesättigten Monomer eingesetzt werden.

Die Polyvinylalkohole können im Rahmen der vorliegenden Erfindung rein oder als Mischung von Polyvinylalkoholen mit unterschiedlichem Polymerisationsgrad oder Hydrolysegrad eingesetzt werden.

Polyvinylacetale enthalten neben den Acetaleinheiten noch aus Vinylacetat und Vinylalkohol resultierende Einheiten. Die erfindungsgemäß verwendeten Polyvinylacetale weisen bevorzugt einen Polyvinylalkoholanteil von weniger als 22 Gew.%, weniger als 20 Gew.%, weniger als 18 Gew.% oder 16 Gew.% und insbesondere weniger als 14 Gew.% auf. Ein Polyvinylalkoholanteil von 10 Gew.% sollte nicht unterschritten werden.

Der Polyvinylacetatgehalt des erfindungsgemäß eingesetzten Polyvinylacetals liegt bevorzugt unter 5 Gew.%, besonders bevorzugt unter 3 Gew.%, ganz besonders bevorzugt unter 1 Gew.%.

Aus dem Polyvinylalkoholanteil und dem Restacetatgehalt kann der Acetalisierungsgrad rechnerisch ermittelt werden.

Bevorzugt weisen die Folien einen Weichmachergehalt von maximal 40 Gew.%, 35 Gew.%, 32 Gew.%, 30 Gew.%, 28 Gew.%, 26 Gew.%, 24 Gew.% oder 22 Gew.% auf, wobei ein Weichmachergehalt von 15 Gew.% aus Gründen der Verarbeitbarkeit der Folie nicht unterschritten werden sollte (jeweils bezogen auf die gesamte Folienformulierung). Erfindungsgemäße Folien bzw. Photovoltaikmodule können einen oder mehrere Weichmacher enthalten.

Geeignete Weichmacher für die erfindungsgemäß eingesetzten Folien sind eine oder mehrere Verbindungen ausgewählt aus den folgenden Gruppen:
- Ester von mehrwertigen aliphatischen oder aromatischen Säuren, z.B. Dialkyladipate wie Dihexyladipat, Dioctyladipat, Hexylcyclohexyladipat, Mischungen aus Heptyl- und Nonyladipaten, Heptylnonyladipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat
- Ester oder Ether von mehrwertigen aliphatischen oder aromatischen Alkoholen oder Oligoetherglykolen mit einem oder mehreren unverzweigen oder verzweigten aliphatischen oder aromatischen Substituenten, wie z.B. Estern von Di-, Tri- oder Tetraglykolen mit linearen oder verzweigten aliphatischen oder cycloaliphatischen Carbonsäuren; Als Beispiele für letztere Gruppe können dienen Diethylenglykol-bis-(2-ethylhexanoat), Triethylenglykol-bis-(2-ethylhexanoat), Triethylenglykol-bis-(2-ethylbutanoat), Tetraethylenglykol-bis-n-heptanoat, Triethylenglykol-bis-n-heptanoat, Triethylenglykol-bis-n-hexanoat, Tetraethylenglykoldimethylether und/oder Dipropylenglykolbenzoat
- Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat
- Ester der Zitronensäure, Bernsteinsäure und/oder Fumarsäure

Besonders geeignet als Weichmacher für die erfindungsgemäß eingesetzten Folien sind eine oder mehrere Verbindungen ausgewählt aus der folgende Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxyethyladipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykolbis-isononanoat, Triethylenglykol-bis-2-propylhexanoat, Tris(2-ethylhexyl)phosphat (TOF), 1,2 Cyclohexandicarbonsäurediisononylester (DINCH), Dihexyladipat (DHA) und Dipropylenglykolbenzoat.

Ganz besonders geeignet als Weichmacher für die erfindungsgemäß eingesetzten Folien sind Weichmacher, deren Polarität, ausgedrückt durch die Formel 100 x O/(C+H) kleiner/gleich 9,4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

**Tabelle 1**

| Name | Polaritätswert |
|---|---|
| Di-2-ethylhexylsebacat (DOS) | 5,3 |
| Diisononylcyclohexandicarbonsäureester | 5,4 |
| (DINCH) | |
| Di-2-ethylhexyladipat (DOA) | 6,3 |
| Di-2-ethylhexylphthalat (DOP) | 6,5 |
| Triethylenglykol-bis-2-propylhexanoat | 8,6 |
| Triethylenglykol-bis-i-nonanoat | 8,6 |
| Di-2-butoxyethylsebacat (DBES) | 9,4 |
| Triethylenglykol-bis-2-ethylhexanoat (3G8) | 9,4 |

Weiterhin kann die möglicherweise vom Wassergehalt der Folie abhängende Ionenbeweglichkeit und damit der spezifische Widerstand durch den Zusatz von SiO₂, insbesondere pyrogener Kieselsäure beeinflusst werden. Bevorzugt enthalten die weichmacherhaltigen, auf Polyvinylacetal basierenden Folien 0.001 bis 15 Gew.%, bevorzugt 0,01 bis 5 Gew.% SiO₂.

Die Vermeidung von Säurespuren bei der Herstellung des Folienmaterials ist eine Möglichkeit, die Korrosionsneigung der erfindungsgemäß eingesetzten Folien gegenüber photosensitiven Halbleiterschichten zu verringern. Folien dieser Art werden in der Regel durch Extrusion unter erhöhten Temperaturen hergestellt, wodurch eine thermische Zersetzung des polymeren Materials bzw. des Weichmachers auftreten kann. Weiterhin kann durch eindiffundiertes Wasser eine Spaltung der Restacetatgruppen des Polyvinylalkohols auftreten, wodurch Essigsäure freigesetzt wird. In beiden Fällen resultieren Säurespuren, die die photosensitiven Halbleiterschichten angreifen können.

Bevorzugt weisen die erfindungsgemäß eingesetzten Folien daher eine gewisse Basizität, ausgedrückt als Alkali-Titer auf, der über 5 oder 10, bevorzugt über 15 und insbesondere über 20, 30 oder 40 liegen sollte. Ein maximaler Alkali-Titer von 100 sollte nicht überschritten werden.

Der Alkali-Titer wird, wie im folgenden beschrieben, durch Rücktitration der Folie bestimmt und kann durch Zugabe von basischen Substanzen, wie z.B. oder mehrere Metallsalze von organischen Carbonsäuren mit 1 bis 15 Kohlenstoffatomen, insbesondere Alkali- oder Erdalkalisalze wie Magnesium- oder Kaliumacetat eingestellt werden. Die basische Verbindung wird üblicherweise in einer Konzentration von 0,005 bis 2 Gew.% insbesondere 0,05 bis 1 Gew.%, bezogen auf die gesamte Mischung eingesetzt.

Weiterhin können die erfindungsgemäßen Folien zusätzlich auch übliche Additive, wie zum Beispiel Oxidationsstabilisatoren, UV-Stabilisatoren, Farbstoffe, Pigmente sowie Antihaftmittel enthalten.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Die Dicke der auf weichmacherhaltigem Polyvinylacetal basierenden Folien liegt üblicherweise zwischen 0,1 und 2,5 mm.

Die Herstellung der Photovoltaikmodule erfolgt durch Laminierung der transparenten Frontabdeckung a), den photosensitiven Halbleiterschichten b) und der rückwärtigen Abdeckung d) mittels mindestens einer weichmacherhaltigen, auf Polyvinylacetal basierenden Folie c) unter Verschmelzung der Folien, so dass ein blasen- und schlierenfreier Einschluss der photosensitiven Halbleiterschicht erhalten wird.

In dieser Variante werden die photosensitiven Halbleiterschichten zwischen zwei Folien c) eingebettet und so mit den Abdeckungen a) und d) verklebt.

Insbesondere bei Dünnschicht-Solarmodulen ist die photosensitive Halbleiterschicht direkt auf einen Träger aufgebracht (z.B. durch Aufdampfen, Gasphasenabscheidung, Sputtern oder Nassabscheidung). Eine Einkapselung der photosensitiven Halbleiterschicht ist hier nicht möglich.

In einer anderen Variante von Photovoltaikmodulen werden die photosensitiven Halbleiterschichten auf die Abdeckung d) aufgebracht (z.B. durch Aufdampfen, Gasphasenabscheidung, Sputtern oder Nassabscheidung) und durch mindestens eine Folie c) mit der transparenten Frontabdeckung a) verklebt.

In einer weiteren Variante werden die photosensitiven Halbleiterschichten auf die transparente Frontabdeckung a) aufgebracht und durch mindestens eine Folie c) mit der rückwärtigen Abdeckung d) verklebt.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung besteht in der Regel aus Glas oder PMMA. Die rückwärtige Abdeckung der Photovoltaikmodule kann aus Glas, Kunststoff oder Metall oder deren Verbünden bestehen, wobei mindestens einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolierverglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Zur Laminierung der so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumringverfahren z.B. gemäß EP 1 235 683 B1 arbeiten bei ca. 200 mbar und 130 bis 145 °C

Vorzugsweise werden zur Herstellung von Photovoltaikmodulen Vakuumlaminatoren eingesetzt. Diese bestehen aus einer beheizbaren und evakuierbaren Kammer, in denen Verbundverglasungen innerhalb von 30 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

### Gewerbliche Anwendbarkeit

Weiterhin ist Gegenstand der Erfindung die Verwendung der genannten weichmacherhaltigen, auf Polyvinylacetal basierenden Folien, zur Herstellung von Photovoltaikmodulen als Fassadenbauteil, Dachflächen, Wintergartenabdeckung, Schallschutzwand, Balkon- oder Brüstungselement oder als Bestandteil von Fensterflächen.

### Messmethoden:

Die Messung des spezifischen Durchgangswiderstandes der Folie erfolgt gemäß DIN IEC 60093 bei definierter Temperatur und Umgebungsfeuchte (23 °C und 85% rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhigkeit R_{z} bei Messung nach DIN EN ISO 4287 nicht größer als 10 µm sein, d.h. gegebenenfalls muss die Originaloberfläche der PVB-Folie vor der Widerstandsmessung durch thermisches Umprägen geglättet werden.

Die Lichtdurchlässigkeiten TL (380-780 nm) wurden mit einem Spektrophotometer (Lambda 950/Fa. PerkinElmer) nach DIN EN410 bestimmt. In Abweichung von DIN EN410 wird die Lichtdurchlässigkeit nicht an einem Glas/Glaslaminat sondern direkt an einer Folie mit einer Rauhigkeit Rz von maximal 10 µm bestimmt.

Die Trübung dL der Folie wurde auf einem Farbmessgerät (Fa. Hunterlab) gemäß ECE R-43 bestimmt.

### Beispiele

Es wurden Folien mit einer Zusammensetzung der folgenden Tabelle auf einem Zweischneckenextruder über ein Breitschlitzwerkzeug hergestellt. Das eingesetzte Polyvinylbutyral PVB (Mowital/Kuraray Europe GmbH) wurde nach bekannten Methoden hergestellt. Der Polyvinylalkohlgehalt des verwendeten Polyvinylbutyrals beträgt 14,3 Gew.%, der Polyvinylacetatgehalt 1,0 Gew.%. Das eingesetzte Antiblockmittel Glycolube P (Pentaerythritoltetrastearat/Fa.Lonza GmbH) wurde vor der Extrusion im Weichmacher DINCH (Diisononylcyclohexandicarbonsäureester, Hexamoll / BASF SE) dispergiert.

Durch die niedrigen Blockingeigenschaften konnten die erfindungsgemäßen Folien bei Raumtemperatur aufgewickelt, für 4 Wochen gelagert und anschließend wieder von Hand abgewickelt werden. Eine Folie gemäß Vergleichsbeispiel konnte bei Raumtemperatur nach 4-wöchiger Lagerung nicht ohne unzulässige Dehnung oder Zerreißen abgewickelt werden und war unbrauchbar.

| Formulierung | Vergleichsbeispiel 1 | Bsp 1 | Bsp 2 | Bsp 3 | Bsp 4 |
|---|---|---|---|---|---|
| PVB [Gew.%] | 74 | 74 | 74 | 74 | 74 |
| DINCH [Gew.%] | 26 | 26 | 26 | 26 | 26 |
| UV-Absorber [Gew.%] | 0,15 | 0,15 | 0,15 | 0,15 | 0,15 |
| Glycolube P | | 0,05 | 0,075 | 0,1 | 0,15 |
| Blockingkraft N/30mm (nach EP0067022) | 73 | 22,8 | 13,1 | 10,8 | 7,5 |
| Durchgangswider stand (23-C/85%r.F.) | 8,9E13 | 8,9E13 | 8,8E13 | 8,8E13 | 8,7E13 |
| Trübung dL (ECE-43) | 0,26 | 1,74 | 1,92 | 2,65 | 3,6 |
| Lichtdurchlässi gkeit TL (EN410) 380-780 nm | 91,9 | 91,9 | 91,8 | 91,8 | 91,7 |

Die erfindungsgemäßen Folien weisen neben der niedrigen Blockingkraft einen hohen Durchgangswiderstand und eine gute Lichtdurchlässigkeit TL auf und sind daher zur Herstellung von Photovoltaikmodulen geeignet.

## Patentansprüche

1. Verwendung von weichmacherhaltigen, auf Polyvinylacetal basierenden Folien, die im T-peel-strength-Test gemäß EP 0067022 B2 bestimmte Eigenhaftung von weniger als 25 N/30 mm und eine Lichtdurchlässigkeit TL nach DIN EN410 von mehr als 85 % aufweisen, zur Herstellung von Photovoltaikmodulen umfassend ein Laminat aus
a. einer transparenten Frontabdeckung
b. einer oder mehreren photosensitiven Halbleiterschichten
c. mindestens einer weichmacherhalteigen, auf Polyvinylacetal basierenden Folie und
d. einer rückwärtigen Abdeckung,
**dadurch gekennzeichnet, dass** die Folie c) 0,001 bis 5 Gew.% mindestes eines der Antiblockmittel ausgewählt aus der Gruppe Ester von mehrwertigen Alkoholen mit mehr als drei Kohlenstoffatomen mit unverzweigten oder verzweigten (Guerbet-Ester), ungesättigten oder gesättigten aliphatischen Carbonsäuren mit 12-26 C-Atomen, Diester von bifunktionellen Alkoholen oder Säuren mit ungesättigten oder gesättigten, verzweigten oder unverzweigten aliphatischen Carbonsäuren bzw. Alkoholen mit 12-26 C-Atomen (Esterwachse), Ester von ungesättigten oder gesättigten, verzweigten oder unverzweigten aliphatischen Carbonsäuren mit 12-26 C-Atomen mit ungesättigten oder gesättigten, verzweigten oder unverzweigten aliphatischen Alkoholen mit 12-26 C-Atomen, Bisamide oligofunktioneller Alkylenamine von ungesättigten oder gesättigten aliphatischen Carbonsäuren mit 12-26 C-Atomen (Amidwachse) enthält.

2. Verwendung nach Anspruch 1, **dadurch gekennzeichnet, dass** als Antiblockmittel 0,001 bis 5 Gew.% eines oder mehrerer Mono-, Di-, Tri oder Tetra-Pentaerythritester der allgemeinen Formel I 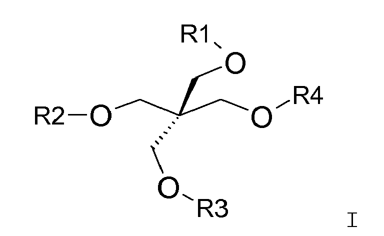 mit R1, R2, R3, R4 = -CO-Alkyl, mit Alkyl= 10-25 C-Atome, oder H; wobei R1, R2, R3, R4 jeweils gleich oder unterschiedlich sein können, aber nicht gleichzeitig H bedeuten, eingesetzt werden.

3. Verwendung nach einem der Ansprüche 1 oder 2, **dadurch gekennzeichnet, dass** dass als Antiblockmittel 0,001 bis 5 Gew.% ein Pentaerythrittetrastearat mit R1, R2, R3, R4 = -C17H35 (Formel II) eingesetzt wird

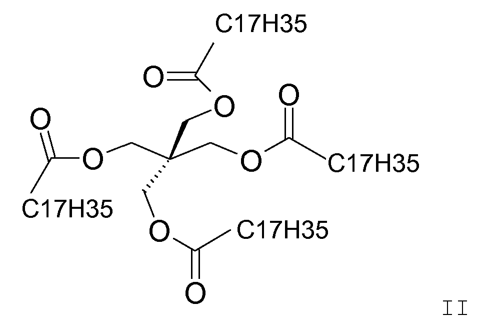

4. Verwendung nach einem der Ansprüche 1 bis 3, **dadurch gekennzeichnet, dass** die weichmacherhaltigen, auf Polyvinylacetal basierenden Folien c) einen Haze von 0,1 bis 20 aufweisen.

5. Verwendung nach einem der Ansprüche 1 bis 4, **dadurch gekennzeichnet, dass** das Polyvinylacetal einen spezifischen Widerstand bei einer Umgebungsfeuchte von 85 rF und 23 °C von mindestens 1E 13 ohm x cm aufweist.

6. Verwendung nach einem der Ansprüche 1 bis 5, **dadurch gekennzeichnet, dass** das Polyvinylacetal einen Polyvinylalkoholanteil von weniger als 22 Gew.% aufweist.

7. Verwendung nach einem der Ansprüche 1 bis 6, **dadurch gekennzeichnet, dass** die weichmacherhaltigen auf Polyvinylacetal basierenden Folien c) ein oder mehrere Metallsalze einer Carbonsäure mit 1 bis 15 Kohlenstoffatomen als basische Verbindung enthalten.

8. Verwendung nach einem der Ansprüche 1 bis 7, **dadurch gekennzeichnet, dass** die weichmacherhaltige, auf Polyvinylacetal basierende Folie 0.001 bis 5 Gew.% SiO₂ enthält.

9. Verwendung nach einem der Ansprüche 1 bis 8, **dadurch gekennzeichnet, dass** die photosensitiven Halbleiterschichten auf die Abdeckung d) aufgebracht und durch mindestens eine weichmacherhaltige, auf Polyvinylacetal basierende Folie c) mit der transparenten Frontabdeckung a) verklebt werden.

10. Verwendung nach einem der Ansprüche 1 bis 8, **dadurch gekennzeichnet, dass** die photosensitiven Halbleiterschichten auf die transparente Frontabdeckung a) aufgebracht und durch mindestens eine weichmacherhaltige, auf Polyvinylacetal basierende Folie c) mit der der rückwärtigen Abdeckung d) verklebt werden.

11. Verwendung nach einem der Ansprüche 1 bis 8, **dadurch gekennzeichnet, dass** eine oder mehrere photosensitive Halbleiterschichten b) zwischen zwei Folien c) eingebettet und mit den Abdeckungen a) und d) verklebt werden.
